# EUROPÄISCHE PATENTSCHRIFT

(11) **EP 1 160 075 B1**
(45) Veröffentlichungstag und Bekanntmachung des Hinweises auf die Patenterteilung: **18.10.2006**
(21) Anmeldenummer: 01113013.5
(22) Anmeldetag: 28.05.2001
(51) Int. Cl.: H01B 7/08, B32B 7/04, B32B 37/00, H05K 3/28

(54) **Halogenfreier Folienverbund, Verfahren zu seiner Herstellung und seine Verwendung**
Halogen-free composite film, process for its manufacture and its use
Feuille composite exempte d'halogène, procédé pour sa fabrication et son utilisation

(30) Priorität: 30.05.2000 DE 10026714
(43) Veröffentlichungstag der Anmeldung: 05.12.2001
(73) Patentinhaber: Hueck Folien GmbH, 4342 Baumgartenberg (AT)
(72) Erfinder: Treutlein, Roland, 92712 Pirk (DE); Geitner, Werner, 92699 Irchenrieth (DE); Kesmarsky, Thomas, Dr., 92712 Pirk (DE)
(74) Vertreter: Hagemeier, Annette

(56) Entgegenhaltungen:
- EP-A- 0 208 138
- EP-A- 0 644 560
- US-A- 3 612 743
- US-A- 4 075 420
- US-A- 4 548 661
- US-A- 5 567 489

## Beschreibung

Die vorliegende Erfindung betrifft einen neuen halogenfreien Folienverbund, ein Verfahren zu seiner Herstellung und seine Verwendung als flexiblen, vielseitig einsetzbaren Werkstoff.

In den letzten Jahren ist der Bedarf an halogenfreien Folien und halogenfreien Verbundfolien auf Grund des wachsenden Umweltbewusstseins und der strengeren gesetzlichen Bestimmungen enorm gestiegen. Durch den Einsatz von halogenfreien Folien wird im Falle eines Brandes die Entstehung von giftigen Umsetzungsprodukten bei der Wärmeentwicklung vermieden. Diesen Anforderungen genügen die bisher hauptsächlich verwendeten Materialien, wie beispielsweise Polyvinylchloridverbindungen, nicht mehr. Außerdem sollen Verbundfolien den Anforderungen nach einer hohen Temperaturbeständigkeit, geringem Schrumpf, sowie einer ausgezeichneten Chemikalienbeständigkeit, insbesondere einer ausgezeichneten Hydrolysebeständigkeit genügen. Darüber hinaus sollen diese Verbundfolien in einfacher Weise und schnell herzustellen sein, damit sie wirtschaftlichen Anforderungen genügen.

Die bekannten Folien, die zur Herstellung von Flachbandkabeln eingesetzt werden, haben den Nachteil, dass sie nicht flexibel genug sind, ein zu hohes Gewicht aufweisen und vor allem nicht ausreichend temperaturbeständig sind. Sie neigen bei hohen Temperaturen zu Delamination. Viele Folien besitzen ungenügende Chemikalienbeständigkeit sowie eine geringe Reißfestigkeit. Wenn die bekannten Folien für Flachbandkabel verwendet werden, kann die eingezogene Litze, falls sie nicht ausreichend geschützt ist, bei bestimmten Anwendungen korrodieren.

So ist beispielsweise aus der DE 42 00 311 A1 ein kleberfreies Flachbandkabel aus amorphen oder teilkristallinen Thermoplasten bekannt, dass durch Heißpressen von Thermoplastbahnen und metallischen Leitern hergestellt wird. Obwohl diese Flachbandleiter eine gute thermische Belastbarkeit und eine lange Lebensdauer aufweisen, haben sie jedoch den Nachteil, dass sie relativ steif und dadurch sehr bruchempfindlich sind. Ein weiterer Nachteil dieser Flachbandkabel besteht in der langsamen Produktionsgeschwindigkeit, so dass eine wirtschaftlich vorteilhafte Herstellung nicht möglich ist. Viele der genannten Polymere weisen eine geringe Haftung gegenüber Kupfer und damit keine guten Siegellackeigenschaften zu diesem Metall auf, so dass sie für viele Anwendungen nicht geeignet sind. Außerdem werden hier zwei Monofolien verwendet, die bei hohen Temperaturen und geringer Herstellungsgeschwindigkeit vollständig in der Presse aufschmelzen und deshalb äußerst schwierig in einer Laminierstation verarbeitet werden können.

Die DE 42 39 982 A1 beschreibt ein Flachbandkabel, das leicht ist, nicht korrodiert und eine ausgezeichnete elektrische Leitfähigkeit aufweist. Das Kabel umfasst eine Vielzahl von aus geschichtetem Graphit bestehende Stromleiter, welche so angeordnet sind, dass sie sich parallel zueinander erstrecken und mit einem aus einem synthetischen Harz geformten elektrisch isolierenden Material ummantelt sind. Diese Flachbandkabel können nicht bei hohen Gebrauchstemperaturen verwendet werden und weisen daher nicht die notwendige Temperaturstabilität auf. Durch die Verwendung von halogenhaltigen Verbindungen zur Verbesserung der elektrischen Leitfähigkeit in Verbindung mit Polyvinylchlorid als synthetischem Harzmaterial, besteht die Gefahr, dass diese Kabel im Falle eines Brandes halogenhaltige Abbauprodukte bilden. Außerdem unterliegen diese halogenhaltigen Flachbandkabel dem Schrumpfen, wodurch sie den modernen Anforderungen nicht mehr genügen. Außerdem können bei diesen Flachbandkabeln Hydrolyseprobleme auftreten, so dass diese Kabel im Kraftfahrzeugbereich nicht eingesetzt werden können.

Die DE-OS 27 44 998 beschreibt eine Flachleiter-Bandleitung, bei der eine Anzahl bandförmiger Leiter im Abstand parallel zueinander verlaufend unter Zwischenschaltung einer Klebschicht festhaftend mit einer Folie aus Isoliermaterial verbunden ist, wobei die Zwischenräume zwischen den Leitern mit einer lichtundurchlässigen und gegen ultraviolette Strahlung beständigen Schicht abgedeckt sind. Diese Flachbandleiter können jedoch nicht bei Anwendungen, bei denen es auf die Lichtdurchlässigkeit der Leiter ankommt, verwendet werden. Außerdem kann während und nach der Produktion keine Qualitätsprüfung der hergestellten Kabel durchgeführt werden.

Die DE 196 32 153 A1 betrifft die Verwendung einer Kunststoffmischung für halogenfreie Kabel auf der Basis von Polypropylen und/oder dessen Copolymeren, die zusätzlich Magnesiumhydroxid enthält. Zur Erreichung der erforderlichen Abriebfestigkeit und der mechanischen Eigenschaften, ohne die erforderliche Flammwidrigkeit zu beeinträchtigen, wird Ethylen-Vinylacetat und/oder dessen Copolymer und das Magnesiumhydroxid oberflächenmodifiziert zugegeben. Durch die Zugabe von Ethylen-Vinylacetat werden die flammwidrigen Eigenschaften durch einen synergistischen Effekt mit Magnesiumhydroxid verbessert. Nachteilig an der Verwendung der oben beschriebenen Kombinationen ist jedoch, dass diese Flachbandkabel eine zu geringe Temperaturbeständigkeit aufweisen und ihre mechanischen und chemischen Eigenschaften nicht ausreichend sind. Besonders im Automobilbereich können polyolefinische Werkstoffe auf Grund ihrer geringen Flammwidrigkeit, ihrer geringen Fließeigenschaften und geringer Formbeständigkeit nicht eingesetzt werden.

Keine der bekannten Folien erfüllt gleichzeitig die Anforderungen nach einer guten Hydrolysebeständigkeit, ausgezeichneter mechanischer und chemischer Beständigkeit, nach Einsatz bei hohen Dauergebrauchstemperaturen, nach guten flammwidrigen Eigenschaften und nach Halogenfreiheit.

Der Erfindung hat deshalb das Ziel, einen halogenfreien Folienverbund sowie ein Verfahren zu dessen Herstellung bereitzustellen, wobei der Folienverbund den oben genannten Anforderungen genügen muß.

Dieses Ziel wird durch einen halogenfreien Folienverbund gemäß dem Anspruch 1 erreicht.

Der erfindungsgemäße halogenfreie Folienverbund besteht aus mindestens zwei bis N siegelfähigen, mehrlagigen Verbundfolien, wobei N eine ganze Zahl von 3 bis 10 ist. Zwischen den einzelnen Verbundfolien ist eine funktionale Schicht und/oder ein funktionales Element vorhanden. Die einzelnen siegelfähigen, mehrlagigen Verbundfolien setzen sich aus einer ersten und einer zweiten Folie zusammen, die mittels eines Kaschierklebers oder -lacks miteinander verbunden werden. Die Folien der einzelnen Verbundfolien können identisch oder verschieden voneinander sein.

Die funktionale Schicht und/oder das funktionale Element ist eine Leiterplatte, ein Sensor, eine metallische Litze oder ein metallisches Leitermaterial oder ein elektronisches Bauteil, wobei das Material für die metallische Litze oder das Leitermaterial ausgewählt wird aus der Gruppe bestehend aus Kupfer, Silber, Eisen, Nickel, Aluminium oder aus einer Legierung dieser Metalle.

Der erfindungsgemäß hergestellte Folienverbund kann bei hohen Dauergebrauchstemperaturen eingesetzt werden, weist gute mechanische Beständigkeiten, insbesondere eine hohe Reißfestigkeit und Reißdehnung, auf, er ist hydrolysebeständig, flammwidrig sowie resistent gegenüber Chemikalien und weist darüber hinaus einen geringen Schrumpf auf.

Das Verfahren zur Herstellung des erfindungsgemäßen Folienverbundes umfaßt die Schritte :
- Auftragen eines Kaschierklebers auf eine erste Folie einer ersten siegelfähigen Verbundfolie,
- Trocknen dieser ersten Folie in einem Trockenkanal bei Temperaturen von 80 bis 180 °C, vorzugsweise 100 bis 120 °C,
- Verbinden einer zweiten Folie am Ende des Trockenkanals mit der ersten Folie, um eine erste siegelfähige Verbundfolie herzustellen,
- Aushärten des Kaschierklebers dieser ersten Verbundfolie,
- Einbringen einer zusätzlichen funktionalen Schicht oder einem zusätzlichen funktionalen Element, ausgewählt aus der Gruppe bestehend aus einer Leiterplatte, einem Sensor, einer metallischen Litze oder einem metallischen Leitermaterial, Kupfer, Silber, Eisen, Nickel, Aluminium oder einer Legierung dieser Metalle, oder einem elektronischen Bauteil, zwischen die erste siegelfähige Verbundfolie und eine zweite siegelfähige Verbundfolie, die in identischer Weise wie die erste Verbundfolie hergestellt wird, und
- Laminieren der ersten Verbundfolie mit der zweiten Verbundfolie.

Falls die Siegeleigenschaften der Verbundfolie im Hinblick auf die weitere Verwendung nicht ausreichend sind, wird die Verbundfolie auf der Seite der zulaufenden zweiten Folie üblicherweise mit einer thermoaktivierbarer Substanz versehen.

Durch diese thermoaktivierbare Substanz wird bewirkt, dass die Siegeleigenschaften der Verbundfolie verbessert werden.

Als erste und/oder zweite Folie können Folien aus der Gruppe, bestehend aus LCP-(Liquid-Crystal-Polymer), PPS-(Polyphenylensulfid-), PET-(Polyethylen-terephthalat-),PEN-(Polyethylennaphthalat-), PK-(Polyketon-), PEK-(Polyetherketon-), PEEK-(Polyetheretherketon-), PEKK-(Polyetherketoketon-), PEEKK- (Polyetheretherketoketon-), PEI-(Polyetherimide), PESU-(Polyethersulfon-), PSU-(Polysulfon-), COC-(Cyclo-Olefin-Copolymer-), sowie Polyamid-Folien ausgewählt werden.

Als Kaschierkleber oder -lack eignen sich insbesondere solche Klebstoffe, die üblicherweise aus Acrylaten, Polyurethanen, Polyesterurethanen, Epoxiden, Copolyestern oder natürlichen Klebeharzen aufgebaut sind. Diese Klebstoffe können als 1- oder Mehr-Komponenten-Systeme eingesetzt werden. Dabei kann es sich um Produkte handeln, die als wässrige Dispersionen, als lösemittelhaltiges oder lösungsmittelfreies System verwendet werden können. Als Beispiele seien hier Produkte der ADCOTE-Reihe der Fa. Rohm & Haas genannt, bei denen es sich um 1- oder Mehr-Komponentenkleber mit guter thermischer Beständigkeit und ausgezeichneter Beständigkeit gegenüber Chemikalien handelt.

Als thermoaktivierbare Substanzen können je nach weiterer Verwendung des Folienverbundes Copolyestersysteme, Cyclo-Olefin-Copolymere, Polyurethane, Acrylate und deren Abkömmlinge, Vinylacetat-Copolymere, Polyvinylalkohole, Polyvinylbutyrale, Polyvinylacetate, siegelfähige Maleinatharze, Alkydharze, Polyolefine und Polyamide verwendet werden. Darüber hinaus können auch gesättigte, ungesättigte, lineare und/oder verzweigte Copolyester, wie beispielsweise Produkte aus der DYNAPOL-Reihe der Fa. Degussa, eingesetzt werden. Diese Materialien zeichnen sich dadurch aus, dass sie durabel, aber gleichzeitig innerlich flexibel und haftfest auf Metallen sind und gute Beständigkeiten gegenüber Chemikalien aufweisen.
Weiterhin können lösungsmittelhaltige Mehr-Komponenten-Polyurethan-Primersysteme verwendet werden, wie beispielsweise Produkte aus der Pentacoll-Reihe der Fa. Rohm & Haas. Diese Kombination von thermisch aktivierbaren Substanzen mit einem Primer ist dann vorteilhaft, wenn eine extrem hohe Verbundfestigkeit erreicht werden soll.

Die einzelnen Verbundfolien werden, wie oben beschrieben, in einer Laminierstation als Folienverbund zur weiteren Verwendung mit einer funktionalen Schicht und/oder einem funktionalen Element zu einem Laminat verbunden. Dabei können die jeweiligen Verbundfolien denselben Aufbau aufweisen, oder in Abhängigkeit von der Anwendung aus verschiedenen ersten und zweiten Folien bestehen und verschiedene Kaschierkleber enthalten.

Der Folienverbund eignet sich als Schutz- oder Deckfolie bei der Herstellung von flexiblen Leiterbahnen.

Darüber hinaus kann der erfindungsgemäße Folienverbund als Abdeckfolie für Leiterplatten verwendet werden. Bei der Verwendung des Folienverbundes im motornahen Bereich ist eine EMV-Schirmung möglich. Auch können die mit der Verbundfolie hergestellten Flachbandkabel für Industrie- Weißgeräte verwendet werden.

Weiterhin kann der Folienverbund zur Herstellung flexibler Flachbandkabel verwendet werden, die bei hohen Gebrauchstemperaturen, wie sie bei der Verwendung im Motorenbereich entstehen, eingesetzt werden, insbesondere im KraftfahrzeugBereich, in der Airbag-Technik, für die Innenverdrahtung von Kraftfahrzeugen, im Dachhimmel von Kraftfahrzeugen, im Motorraum, sowie bei Scheinwerfern. Besonders im Motorraum und für Scheinwerfer ist eine Dauergebrauchstemperatur von über 140°C erforderlich, diese Anwendung ist mit dem erfindungsgemäßen Folienverbund ohne Probleme möglich.

Als metallische Leiter für die Herstellung von Flachbandkabeln können alle Materialien verwendet werden, die elektrischen Strom leiten. Als Metalle kommen alle üblichen Leitermetalle, wie z.B. Kupfer, Silber, Eisen, Nickel, Aluminium bzw. Legierungen dieser Metalle in Frage. Die Dicke der zur verarbeitenden Metalle kann bis zu 200 µm reichen.

Außerdem kann der Folienverbund als Schutzfolie und/oder Deckfolie für flexible Leiterbahnen verwendet werden.

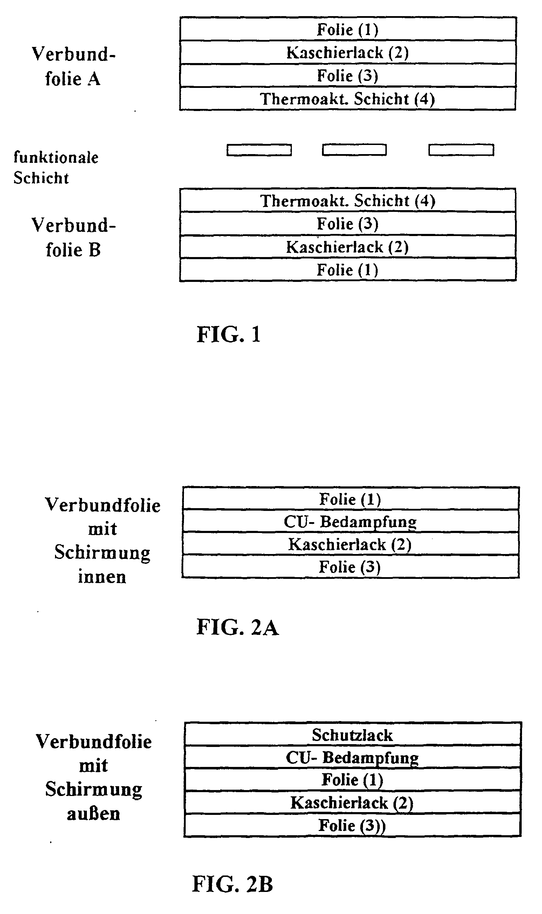

Figur 1 zeigt den Aufbau eines Flachbandkabels, das mit dem Folienverbund hergestellt wurde.

Für die Herstellung von Flachbandkabeln werden zwei identische oder unterschiedliche Verbundfolien A und B, die aus einer Folie 1, einem Kaschierlack 2, einer Folie 3 und ggf. einer thermoaktiverbaren Substanz 4 aufgebaut sind, verwendet. Als funktionale Schicht wird ein metallischer Leiter, beispielsweise Kupferlitzen, zwischen zwei Bahnen der Verbundfolien A und B kaschiert. Das Verfahren wird so durchgeführt, dass eine Kupferfolie auf der Laminiermaschine in schmale Bahnen geschnitten und mittels heißen Laminierwalzen bei Temperaturen von 150°C bis 400°C, vorzugsweise 180°C bis 280°C zwischen den beiden Folienbahnen einlaminiert wird. In der Kaschierstation werden die beiden Folienbahnen mit dem metallischen Leiter in der Zwischenlage durch Druck und Temperatur zusammengesiegelt. Durch diese Druck- und Temperaturbehandlung wird die thermoaktivierbare Substanz oder Siegelfolie thermoplastisch und verbindet sich mit der zweiten Folienbahn.

Ein wesentlicher Vorteil des erfindungsgemäßen Folienverbundes liegt darin, dass er bei Dauergebrauchstemperaturen von 140°C und mehr eingesetzt werden kann. Darüber hinaus weist der Folienverbund eine große Flexibilität, gute thermische Beständigkeit, geringen Schrumpf, gute mechanische Eigenschaften, wie Reißfestigkeit und Reißdehnung, gute chemische Eigenschaften, beispielsweise Lösungsmittelbeständigkeit, Beständigkeit gegenüber Säuren, insbesondere Batteriesäure, und Basen, sowie gegen alle Arten von Ölen, wie Motorenöl, Automatikgetriebeöl, Getriebeöl, Kraftstoffe, Bremsflüssigkeit, Kühlerfrostschutzmittel, unverdünnter Scheibenreinigungsflüssigkeit und dergleichen, auf.

Darüber hinaus ist im Verbund mit einer elektrisch leitenden Schicht eine elektromagnetische Schirmung, z.B. mit Metallbedampfung oder Metallfolienkaschierung möglich. Die Figuren 2A und 2B zeigen jeweils eine Verbundfolie mit einer Schirmung innen und eine Verbundfolie mit einer Schirmung außen.
Zur Herstellung einer Verbundfolie mit einer Schirmung innen Fig. 2A wird die Außenfolie 1 vor dem Kaschierarbeitsgang in einem separaten Arbeitsgang kupferbedampft. In der Kaschieranlage wird dann auf die kupferbedampfte Seite der Kaschierkleber 2 aufgebracht. Anschließend wird, wie oben beschrieben, die zweite Folie 3 aufgebracht. Bei einer Verbundfolie, die eine Außenschirmung Fig. 2B aufweisen soll, wird auf die kupferbedampfte Folie 1 ein Schutzlack aufgetragen und dann auf die erste Folie der Kaschierkleber 2 aufgetragen und anschließend, wie bereits oben beschrieben, die zweite Folie 3 aufgebracht.

Die EMV-Schirmung ist zum einen erforderlich, wenn eine ungerade Anzahl von metallischen Litzen in den Folienverbund eingelegt wird und zum anderen, falls die Flachbandleitung an anderen elektronischen Bauteilen vorbeigeführt wird. Hier würde das elektrische oder magnetische Feld des nicht geschirmten Kabels zur Störung des Betriebes der anderen elektrischen Bauteile führen (z.B. Radio, Fensterheber, etc.). Mit einer kupferbedampften Schicht können Schirmungen von 60 bis 80 dB bei Frequenzen ab 500 MHz erzielt werden, die außerdem vergleichsweise preisgünstig integriert werden können.

Der Folienverbund kann ohne Probleme weiteren Arbeitsgängen, wie Laserschweißen, Oberflächenschweißen, Punktschweißen, Ultraschallschweißen, Crimpen, der Abisolierung mittels Laser und dergleichen, zugeführt werden.

Die nachfolgend genannten Folien können für die Herstellung der Verbundfolie und damit für den Folienverbund gemäß den weiteren Anwendungen verwendet werden.

PPS-(Polyphenylensulfid-) Folie weist eine hohe thermische Beständigkeit von 160°C bis 180°C auf und ist deshalb insbesondere für die Verwendung einer Folie, die den Anforderungen einer hohen Temperaturbeständigkeit genügen muß, geeignet.

PET-(Polyethylenterephthalat-) Folie weist eine obere Schmelztemperatur von 255°C bis 260°C auf und ist deshalb ebenfalls für einen Gebrauch bei hohen Dauergebrauchstemperaturen geeignet.

PEN-(Polyethylennaphthalat-) Folie ist hydrolysebeständig, UV-witterungsbeständig und weist eine Dauergebrauchstemperatur von ca. 155°C auf. Sie ist deshalb ebenfalls für Anwendungen geeignet, für die hohe Dauergebrauchstemperaturen erforderlich sind.

PK-(Polyketon-) Folie ist eine halogenfreie Folie, die gute flammwidrige Eigenschaften, sowie ausgezeichnete Hydrolysebeständigkeit aufweist. Unter den Folien, die auf Polyketon bzw. Polyetherketon basieren, eignen sich außerdem nachfolgend genannte Folien, PEK (Polyetherketon), PEEK (Polyetheretherketon), PEKK (Polyetherketoketon), PEEKK (Polyetheretherketoketon), PEI (Polyetherimid), PESU (Polyethersulfon), sowie PSU (Polysulfon).

COC-(Cyclo-Olefin-Copolymer-) Folie ist beständig gegenüber Säuren und Basen sowie gegenüber aliphatischen Lösungsmitteln, sie weist eine hohe Transparenz, eine niedrige Dichte und eine außerordentlich geringe Wasseraufnahme auf, sie ist insbesondere bis 170°C Wärmeformbeständigkeit, hat eine hohe Steifigkeit, Festigkeit und Härte.

Aus der Familie der Polyamid-Folien werden vorzugsweise die PA 6- oder PA 12-Folien sowie deren Copolymerisate verwendet. Die PA-Folien zeichnen sich hohe Festigkeit, ausgezeichnete Zähigkeit, gute Thermoverformbarkeit, hohe Wärmebeständigkeit und Siegelbarkeit aus. Bei entsprechender Ausrüstung (Additivierung) erhält man zudem auch eine gute Hydrolysebeständigkeit.

Die oben genannten Folien genügen den eingangs genannten Anforderungen nach guter Hydrolysebeständigkeit, ausgezeichneter mechanischer und chemischer Beständigkeit, Verwendung bei hohen Dauergebrauchstemperaturen, Flammwidrigkeit, Halogenfreiheit nicht. Überraschenderweise hat sich jedoch gezeigt, dass die erfindungsgemäße Kombination von verschiedenen Folien in den Verbundfolien und damit im Folienverbund, die mit einem Kaschierkleber und ggf. einer thermoaktivierbaren Substanz in einer Verbundfolie ausgestattet sind, zu den oben genannten vorteilhaften Eigenschaften führt, so dass sich ein flexibler Werkstoff ergibt, der vielfältig einsetzbar ist.

Die einzelnen Folien haben je nach weiterer Verwendung eine Dicke von 10 µm bis 100 µm.

Vorteilhafterweise liegt das Nassauftragsgewicht des Kaschierklebers bei 2 g/m² bis 40 g/m², vorzugsweise 4 g/m² bis 10 g/m² Nassauftrag, dies entspricht einem Trockenauftrag von 2 g/m² bis 5 g/m², vorzugsweise 3 g/m².

Die aufgetragene Kleberschicht wird bei Temperaturen von 80°C bis 180°C, vorzugsweise 100°C bis 120°C getrocknet.

Die oben genannten thermoaktivierbaren Substanzen können aus der Lösung (Lack) oder aus der Schmelze (Hot-melt) aufgetragen werden. Durch einen, je nach weiterer Anwendung, gewählten Reaktionsmechanismus kann beim Laminieren, d.h. der Herstellung des Folienverbundes der beiden Verbundfolien eine Reaktion in Gang gesetzt werden, die eine Umformung der thermoplastischen Substanz in eine duroplastische Beschichtung bzw. eine deutliche Erhöhung des Erweichungspunktes der Beschichtung bewirkt.

Der erfindungsgemäße Folienverbund setzt sich vorzugsweise wie folgt zusammen:

In einer ersten Ausführungsform ist die erste Folie einer Verbundfolie eine PPS-Folie, auf die der Kaschierlack aufgetragen wird und anschließend mit einer siegelbaren PET-Folie als zweiter Folie verbunden wird, ggf. wird diese zweite Folie mit einem thermoaktivierbaren Substanz, versehen. In einer zweiten Ausführungsform ist die erste Folie der Verbundfolie eine PPS-Folie, die mit einer Schicht Kaschierlack versehen ist und anschließend mit einer PEN-Folie als zweiter Folie verbunden wird, die ggf. eine Schicht thermoaktivierbarer Substanz aufweist.
In einer weiteren Ausführungsform ist die erste Folie der Verbundfolie eine PPS-Folie, die eine Kaschierlackschicht aufweist und anschließend mit einer PA-Folie als zweiter Folie oder einem anderen thermoplastischen Kunststoff verbunden wird, ggf. kann die zweite Folie mit einer thermoaktivierbaren Substanz beschichtet sein.
Die jeweils zweiten Verbundfolien des Folienverbundes können nun einen identischen oder verschiedenen Aufbau wie die jeweils ersten Verbundfolien aufweisen.
Die so hergestellten Verbundfolien weisen eine hohe Reißfestigkeit, Chemikalienbeständigkeit, Hydrolysebeständigkeit und Flammwidrigkeit auf und sind darüber hinaus bei Temperaturen von 140°C und mehr einsetzbar.

Der Folienverbund für ein Flachbandkabel setzt sich beispielsweise aus mindestens zwei identisch oder unterschiedlich aufgebauten Verbundfolien zusammen. Nicht nur bei der Herstellung von Flachbandkabeln kann es sinnvoll sein, dass die inneren Folienmaterialien der jeweiligen Verbundfolien im allgemeinen einen tieferen Schmelzpunkt als die äußeren Folienmaterialien der jeweiligen Verbundfolien aufweisen. Durch die Druck- und Temperaturbehandlung in der Laminieranlage werden das einzulaminierende Metall und die beiden Verbundfolien durch die thermoaktivierbare Substanz miteinander verbunden. Es hat sich gezeigt, dass bei Verwendung einer sehr dünnen Metalllitze kein oder kaum thermoaktivierbare Substanz zur Verbindung des Metalls mit den beiden Verbundfolien erforderlich ist.

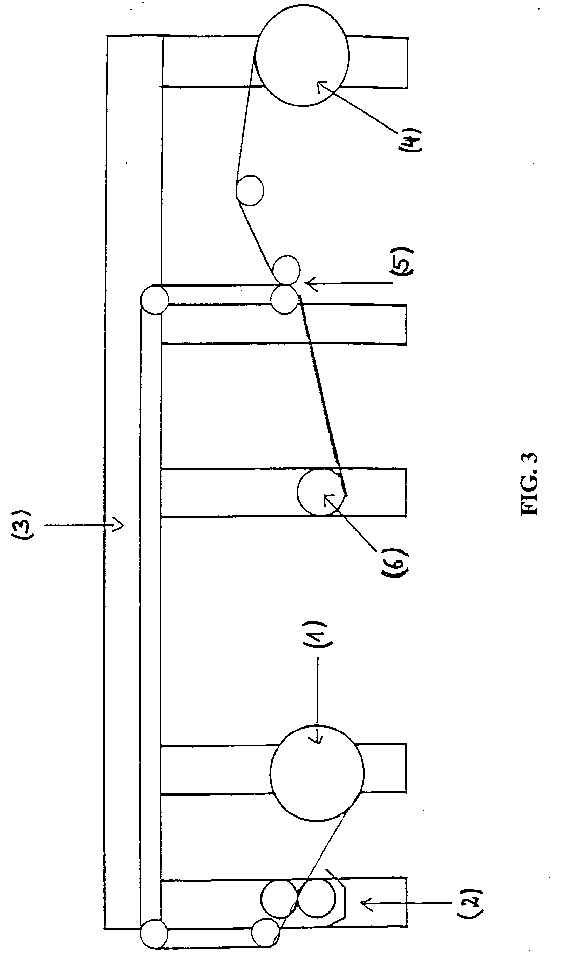

Figur 3 zeigt eine schematische Darstellung der Lackier- und Kaschieranlage zur Herstellung der Verbundfolie. Die zu kaschierenden Folie befindet sich auf der Rolle 1, diese Folie wird zum Auftragswerk 2 transportiert, wo mittels geeigneter Auftragstechnologien, wie z.B. Glattwalzenauftrag, Rasterwalzenauftrag, Streichauftrag, der Kaschierkleber aufgetragen wird. Nach dem Auftragen des Kaschierklebers wird die beschichtete Folie in den Trockenkanal 3 transportiert. Am Ende des Trockenkanals befindet sich eine Abwickelvorrichtung mit einer weiteren Folie 4, die beiden Folien werden in der Kaschierstation 5 miteinander verbunden. Anschließend wird diese Verbundfolie mittels einer geeigneten Vorrichtung 6 aufgewickelt und der Kleber ausgehärtet. Bei Bedarf wird die zulaufende Folie mit einer thermoaktivierbaren Substanz beschichtet.

### Beispiel 1

Zur Herstellung einer ersten Verbundfolie wurde als erste Folie eine PPS-Folie verwendet. Auf diese Folie wurde dann ein auf Polyurethan basierender Kaschierkleber mittels geeigneter Auftragstechnologie, je nach weiterer Verwendung mittels Glattwalzenauftrag, Rasterwalzenauftrag, Streichauftrag oder Kammerrakelsystem appliziert. Vorteilhafterweise liegt das Auftragsgewicht des Kaschierklebers bei 2 g/m² bis 40 g/m², vorzugsweise 4 g/m² bis 10 g/m² Nassauftrag, dies entspricht einem Trockenauftrag von 2 g/m² bis 5 g/m², vorzugsweise 3 g/m².
Ein Rasterwalzenauftrag ist dann zu verwenden, wenn eine glatte, glänzende und optisch attraktive Folie erhalten werden soll.
Die so aufgetragene Kleberschicht wurde in einem Trockenkanal bei Temperaturen von 80 °C bis 180°C, vorzugsweise 100 °C bis 120 °C getrocknet. Dabei verdunsteten die eingesetzten Lösungsmittel und der noch leicht klebrige Kaschierlack blieb zurück.
Am Ende des Trockenkanals wurde die kleberbeschichtete Folie in einer Kaschierstation mit der zulaufenden zweiten Folie verbunden. Der Verbund wurde aufgewickelt und der Kleber in einem Zeitraum von 3 bis 10 Tagen zur endgültigen Festigkeit ausgehärtet.

### Beispiel 2

Die nach Beispiel 1 hergestellte Verbundfolie kann bei Bedarf auf der Siegelfolienseite der zulaufenden Folie mit einer thermoaktivierbaren Substanz, beispielsweise einem gesättigten, verzweigten Copolyester, in der oben genannten Auftragstechnologie beschichtet werden.
Diese Beschichtung mit einer thermoaktivierbaren Substanz empfiehlt sich insbesondere, bei der Herstellung von Flachbandkabeln, da die beiden Verbundfolien zwar zu sich selbst siegelfähig, nicht aber zu den verwendeten Metalllitzen, beispielsweise Cu oder Cu-Ni, sind. Bei einer sehr dünnen Metallfolie von bis zu 30 µm kann auf die thermoaktivierbare Substanz ggf. verzichtet werden

### Beispiel 3

Zur Herstellung eines flexiblen Flachbandkabels wurden zwei Verbundfolien, die wie in Beispiel 1 beschrieben, hergestellt wurden, laminiert. In diesem Beispiel wurde als metallischer Leiter Kupferlitze verwendet. Diese Kupferlitzen wurden in Folienform auf der Laminiermaschine in schmale Bahnen von 0,3 bis 50 mm, je nach Anwendung, geschnitten und mittels heißen Laminierwalzen bei 150 °C bis 400 °C, vorzugsweise 180 °C bis 280 °C zwischen die beiden Verbundfolien einlaminiert. Bei diesem Vorgang wird die thermoaktivierbare Substanz oder die zweite Folie der ersten Verbundfolie thermoplastisch und verschmilzt mit der Lackschicht der zweiten Verbundfolie.

### Beispiel 4

Zur Herstellung einer Isolierfolie für ein flexibles Flachbandkabel wurde als Verbundfolie eine Folie aus PPS und vorbehandelte heißsiegelfähige Polyesterfolie oder eine Polyamidfolie in unterschiedlichen Folienstärken von jeweils 25, 35, 50 und 75 µm verwendet. Als Kaschierkleber wurde ein Polyurethansystem verwendet. Als Leitermaterial wurde Kupfer in Form von gewalzten Drähten oder geschnittenen Folien verwendet, wobei das Leitermaterial eine Dicke von 0,01 mm bis 0,3 mm und eine Breite von 0,3 mm bis 50 mm aufwies. Die zu laminierenden Verbundfolien wurden über Heizwalzen mit einer Walzentemperatur von 150 °C bis 200 °C verpresst. Die Laminiergeschwindigkeit betrug 5 m/min bis 50 m/min.

Das so hergestellte Flachbandkabel zeigte im Siegelbereich keine Lufteinschlüsse und darüber hinaus am fertigen Kabel an den Leiterkanten keine Kapillarwirkung. Es war resistent gegenüber Chemikalien, insbesondere gegenüber diverser Kraftstoffen, Säuren, Frostschutzmitteln, es wies eine ausgezeichnete Temperaturbeständigkeit auf, war hydrolysebeständig, konnte halogenfrei hergestellt werden und zeigte ausgezeichnete flammwidrige Eigenschaften.

### Beispiel 5

Zur Herstellung einer Verbundfolie mit einer Schirmung innen wird die als Außenfolie eingesetzte PPS-Folie vor dem Kaschierarbeitsgang in einem separaten Arbeitsgang kupferbedampft. In der Kaschieranlage wird dann auf die kupferbedampfte Seite der Kaschierkleber aufgebracht. Anschließend wird, wie oben beschrieben, die zweite Folie aufgebracht.
Bei einer Verbundfolie, die eine Außenschirmung aufweisen soll, wird auf die kupferbedampfte PPS-Folie ein Schutzlack aufgetragen und dann auf die erste Folie der Kaschierkleber aufgetragen und anschließend die zweite Folie mit der ersten verbunden.

## Patentansprüche

1. Halogenfreier Folienverbund bestehend aus mindestens zwei bis N siegelfähigen, mehrlagigen Verbundfolien, wobei N eine ganze Zahl von 3 bis 10 ist, jede mehrlagige siegelfähige Verbundfolie umfaßt eine erste Folie, eine zweite Folie und zwischen der ersten und der zweiten Folie einen Kaschierkleber oder-lack, wobei eine Seite der Verbundfolien siegelfähig mit einer zusätzlichen funktionalen Schicht oder einem zusätzlichen funktionalen Element verbunden ist, wobei die funktionale Schicht oder das funktionale Element aus der Gruppe bestehend aus einer Leiterplatte, einem Sensor, einer metallischen Litze oder einem metallischen Leitermaterial, insbesondere Kupfer, Silber, Eisen, Nickel, Aluminium oder einer Legierung dieser Metalle, oder einem elektronischen Bauteil ausgewählt werden.

2. Folienverbund nach Anspruch 1, **dadurch gekennzeichnet, dass** die einzelnen Folien der siegelfähigen, mehrlagigen Verbundfolien identisch oder verschieden voneinander sind.

3. Folienverbund nach einem der Ansprüche 1 oder 2, **dadurch gekennzeichnet, dass** die jeweils zweiten Folien der Verbundfolien mit einer thermoaktivierbaren Substanz ausgestattet sind.

4. Folienverbund nach einem der Ansprüche 1 bis 3, **dadurch gekennzeichnet, dass** die jeweils erste und die zweite Folie jeder einzelnen Verbundfolien ausgewählt werden aus der Gruppe, bestehend aus LCP-(Liquid-Crystal-Polymer), Polyphenylen-sulfid-, Polyethylenterephthalat-, Polyethylennaphthalat-, Polyketon-, Polyetherketon-, Polyetheretherketon-, Polyetherketoketon-, Polyetheretherketoketon-, Polyetherimide, Polyethersulfon-, Polysulfon-, Cyclo-Olefin-Copolymer- und Polyamid-Folien.

5. Folienverbund nach einem der Ansprüche 1 bis 4, **dadurch gekennzeichnet, dass** der Kaschierkleber oder -lack ausgewählt wird aus der Gruppe, bestehend aus Acrylaten, Polyurethanen, Polyesterpolyolen, Polyesterurethanen, Epoxiden, Copolyestern oder natürlichen Klebeharzen, die als 1-Komponenten- oder Mehr-Komponenten-Systeme eingesetzt werden.

6. Folienverbund nach einem der Ansprüche 1 bis 5, **dadurch gekennzeichnet, dass** das Nassauftragsgewicht des Kaschierklebers 2 g/m² bis 40 g/m², vorzugsweise 4 g/m² bis 10 g/m² beträgt.

7. Folienverbund nach einem der Ansprüche 3 bis 6, **dadurch gekennzeichnet, dass** die thermoaktivierbare Substanz ausgewählt wird aus der Gruppe bestehend aus Cycloolefincopolymeren, Polyestern, Polyurethanen, Acrylaten und deren Abkömmlingen, Vinylacetat-Copolymere, Polyvinylalkohole, Polyvinylbutyrale, Polyvinylacetate, siegelfähige Maleinatharze, Alkydharze, Polyolefine, Polyamide, sowie gesättigten, ungesättigten, linearen und/oder verzweigten Copolyestern oder Mehr-Komponenten-Polyurethan-Primersystemen.

8. Folienverbund nach einem der Ansprüche 1 bis 7, **dadurch gekennzeichnet, dass** die erste und zweite Folie der einzelnen Verbundfolien jeweils eine Stärke von 10 µm bis 100 µm besitzen.

9. Verfahren zur Herstellung eines halogenfreien Folienverbundes umfassend die Schritte:
- Auftragen eines Kaschierklebers auf eine erste Folie einer ersten siegelfähigen Verbundfolie,
- Trocknen dieser ersten Folie in einem Trockenkanal bei Temperaturen von 80 bis 180 °C, vorzugsweise 100 bis 120 °C,
- Verbinden einer zweiten Folie am Ende des Trockenkanals mit der ersten Folie, um eine erste siegelfähige Verbundfolie herzustellen,
- Aushärten des Kaschierklebers dieser ersten Verbundfolie,
- Einbringen einer zusätzlichen funktionalen Schicht oder einem zusätzlichen funktionalen Element, ausgewählt aus der Gruppe bestehend aus einer Leiterplatte, einem Sensor, einer metallischen Litze oder einem metallischen Leitermaterial, Kupfer, Silber, Eisen, Nickel, Aluminium oder einer Legierung dieser Metalle, oder einem elektronischen Bauteil, zwischen die erste siegelfähige Verbundfolie und eine zweite siegelfähige Verbundfolie, die in identischer Weise wie die erste Verbundfolie hergestellt wird, und
- Laminieren der ersten Verbundfolie mit der zweiten Verbundfolie.

10. Verfahren nach Anspruch 9, **dadurch gekennzeichnet, daß** der Folienverbund aus mindestens zwei bis N siegelfähigen, mehrlagigen Verbundfolien besteht, wobei N eine ganze Zahl von 3 bis 10 ist.

11. Verfahren nach einem der Ansprüche 9 oder 10, **dadurch gekennzeichnet, dass** die zweite Folie der einzelnen Verbundfolien mit einer thermoaktivierbaren Substanz beschichtet ist.

12. Verfahren nach einem der Ansprüche 9 bis 11, **dadurch gekennzeichnet, dass** die erste und zweite Folie jeder einzelnen Verbundfolien identisch oder verschieden voneinander sind und ausgewählt werden aus der Gruppe, bestehend aus LCP-(Liquid-Cyrstal-Polymer), Polyphenylensulfid-, Polyethylenterephthalat-, Polyethylennaphthalat-, Polyketon-, Polyetherketon-, Polyetheretherketon-, Polyetherketoketon-, Polyetheretherketoketon-, Polyetherimide, Polyethersulfon-, Polysulfon-, Cyclo-Olefin-Copolymer- und Polyamid-Folien.

13. Verfahren nach einem der Ansprüche 9 bis 12, **dadurch gekennzeichnet, dass** der Kaschierkleber ausgewählt wird aus der Gruppe, bestehend aus Acrylaten, Polyurethanen, Polyesterpolyolen, Polyesterurethanen, Epoxiden, Copolyestern oder natürlichen Klebeharzen, die als 1-Komponenten- oder Mehr-Komponenten-Systeme eingesetzt werden.

14. Verfahren nach einem der vorherigen Ansprüche 9 bis 13, **dadurch gekennzeichnet, dass** das Nassauftragsgewicht des Kaschierklebers 2 g/m² bis 40 g/m², vorzugsweise 4 g/m² bis 10 g/m² beträgt.

15. Verfahren nach Anspruch 11, **dadurch gekennzeichnet, dass** die thermoaktivierbare Substanz ausgewählt wird aus der Gruppe bestehend aus Cycloolefincopolymere, Polyestern, Polyurethanen, Acrylaten und deren Abkömmlingen, Vinylacetat-Copolymere, Polyvinylalkohole, Polyvinylbutyrale, Polyvinylacetate, siegelfähige Maleinatharze, Alkydharze, Polyolefine, Polyamide, sowie gesättigten, ungesättigten, linearen und/oder verzweigten Copolyestern oder Mehr-Komponenten-Polyurethan-Primersystemen.

16. Verfahren nach einem der vorherigen Ansprüche 9 bis 15, **dadurch gekennzeichnet, dass** die erste und zweite Folie der einzelnen Verbundfolien eine Stärke von 10 µm bis 100 µm aufweisen.

17. Verwendung des Folienverbundes nach einem der Ansprüche 1 bis 8 als Deckfolie und/oder Schutzfolie für flexible Leiterbahnen, elektronische Bauteile, Sensoren.

18. Verwendung des Folienverbundes nach einem der Ansprüche 1 bis 8 für die Herstellung von flexiblen Flachbandkabeln.

19. Verwendung des Folienverbundes nach einem der Ansprüche 1 bis 8 zur elektromagnetischen Schirmung im Verbund mit einer elektrisch leitenden Schicht, **dadurch gekennzeichnet, dass** entweder zwischen den einzelnen Verbundfolien oder auf dem fertiggestellten Folienverbund eine Metallschicht aufgedampft wird.

20. Verwendung nach Anspruch 19, **dadurch gekennzeichnet, dass** die aufgedampfte Metallschicht aus Kupfer oder Aluminium besteht.

## Claims

1. Halogen-free laminated composite consisting of at least two up to N heat-sealable multilayer composite films, where N is a whole number from 3 to 10, each multilayer heat-sealable composite film comprises a first film, a second film and between the first and second films a laminating adhesive or lacquer, where one side of the composite films is attached in heat-sealable form to an additional functional layer or element, the functional layer or element being selected from the group comprising a printed circuit board, a sensor, a metal litz wire or metal conductive material, in particular copper, silver, iron, nickel, aluminium or an alloy of these metals, or an electronic component.

2. Laminated composite according to Claim 1, **characterised in that** the individual films of the heat-sealable, multilayer composite films are identical or different from one another.

3. Laminated composite according to Claim 1 or 2, **characterised in that** the second film of each composite film is equipped with a thermoactivatable substance.

4. Laminated composite according to one of Claims 1 to 3, **characterised in that** the first and second films of each individual composite film are selected from the group comprising LCP (liquid crystal polymer), polyphenylene sulfide, polyethylene terephthalate, polyethylene naphthalate, polyketone, polyetherketone, polyetheretherketone, polyetherketoketone, polyetheretherketoketone, polyether imides, polyether sulfone, polysulfone, cycloolefin copolymer and polyamide films.

5. Laminated composite according to one of Claims 1 to 4, **characterised in that** the laminating adhesive or lacquer is selected from the group comprising acrylates, polyurethanes, polyester polyols, polyester urethanes, epoxides, copolyesters or natural adhesive resins used as one-component or multi-component systems.

6. Laminated composite according to one of Claims 1 to 5, **characterised in that** the wet application weight of the laminating adhesive is 2 g/m² to 40 g/m², preferably 4 g/m² to 10 g/m².

7. Laminated composite according to one of Claims 3 to 6, **characterised in that** the thermoactivatable substance is selected from the group comprising cycloolefin copolymers, polyesters, polyurethanes, acrylates and their derivatives, vinyl acetate copolymers, polyvinyl alcohols, polyvinyl butyrals, polyvinyl acetates, heat-sealable maleic resins, alkyd resins, polyolefins, polyamides and also saturated, unsaturated, linear and/or branched copolyesters or multi-component polyurethane primer systems.

8. Laminated composite according to one of Claims 1 to 7, **characterised in that** the first and second films of the individual composite films each have a thickness of 10 µm to 100 µm.

9. Method for producing a halogen-free laminated composite comprising the steps:
- application of a laminating adhesive to a first film of a first heat-sealable composite film,
- drying of this first film in a drying tunnel at temperatures of 80 to 180 °C, preferably 100 to 120 °C,
- joining of a second film at the end of the drying tunnel to the first film in order to obtain a first heat-sealable composite film,
- curing of the laminating adhesive of this first composite film,
- insertion of an additional functional layer or element, selected from the group comprising a printed circuit board, sensor, metal litz wire or metal conductive material, copper, silver, iron, nickel, aluminium or an alloy of these metals, or an electronic component, between the first heat-sealable composite film and a second heat-sealable composite film produced in an identical manner to the first composite film, and
- laminating of the first composite film to the second composite film.

10. Method according to Claim 9, **characterised in that** the laminated composite consists of at least two to N heat-sealable, multilayer composite films, where N is a whole number from 3 to 10.

11. Method according to Claim 9 or 10, **characterised in that** the second film of the individual composite films is coated with a thermoactivatable substance.

12. Method according to one of Claims 9 to 11, **characterised in that** the first and second films of each individual composite film are identical or different from one another and are selected from the group comprising LCP (liquid crystal polymer), polyphenylene sulfide, polyethylene terephthalate, polyethylene naphthalate, polyketone, polyetherketone, polyetheretherketone, polyetherketoketone, polyetheretherketoketone, polyether imides, polyether sulfone, polysulfone, cycloolefin copolymer and polyamide films.

13. Method according to one of Claims 9 to 12, **characterised in that** the laminating adhesive is selected from the group comprising acrylates, polyurethanes, polyester polyols, polyester urethanes, epoxides, copolyesters or natural adhesive resins used as one-component or multi-component systems.

14. Method according to one of the foregoing Claims 9 to 13, **characterised in that** the wet application weight of the laminating adhesive is 2 g/m² to 40 g/m², preferably 4 g/m² to 10 g/m².

15. Method according to Claim 11, **characterised in that** the thermoactivatable substance is selected from the group comprising cycloolefin copolymers, polyesters, polyurethanes, acrylates and their derivatives, vinyl acetate copolymers, polyvinyl alcohols, polyvinyl butyrals, polyvinyl acetates, heat-sealable maleic resins, alkyd resins, polyolefins, polyamides and also saturated, unsaturated, linear and/or branched copolyesters or multi-component polyurethane primer systems.

16. Method according to one of the foregoing Claims 9 to 15, **characterised in that** the first and second films of the individual composite films have a thickness of 10 µm to 100 µm.

17. Use of the laminated composite according to one of Claims 1 to 8 as an overlay and/or protective film for flexible printed circuits, electronic components, sensors.

18. Use of the laminated composite according to one of Claims 1 to 8 for manufacturing flexible ribbon cables.

19. Use of the laminated composite according to one of Claims 1 to 8 for electromagnetic screening bonded to an electrically conductive layer, **characterised in that** a metal coating is vapour-deposited either between the individual composite films or on the finished laminated composite.

20. Use according to Claim 9, **characterised in that** the vapour-deposited metal coating consists of copper or aluminium.

## Revendications

1. Composite de feuilles sans halogène constitué au moins de deux à n feuilles composées multicouches scellables, n étant un nombre entier de 3 à 10, chaque feuille composée multicouche scellable comprenant une première feuille et une seconde feuille, entre lesquelles se trouve une colle ou une laque de revêtement, une face des feuilles composées étant reliée de manière scellable à une couche fonctionnelle supplémentaire ou un élément fonctionnel supplémentaire, la couche fonctionnelle ou l'élément fonctionnel étant choisi parmi un groupe comprenant une plaquette imprimée, un détecteur, un cordon métallique ou une matière conductrice métallique, en particulier du cuivre, de l'argent, du fer, du nickel, de l'aluminium ou un alliage de ces métaux ou un composant électronique.

2. Composite de feuilles sans halogène suivant la revendication 1, **caractérisé en ce que** les différentes feuilles des feuilles composées multicouches scellables sont identiques ou différentes l'une de l'autre.

3. Composite de feuilles suivant une des revendications 1 ou 2, **caractérisé en ce que** les secondes feuilles des feuilles composées sont respectivement pourvues d'une substance thermoactivable.

4. Composite de feuilles suivant une des revendications 1 à 3, **caractérisé en ce que** la première et la seconde feuille de chacune des feuilles composées sont respectivement choisies parmi un groupe comprenant des feuilles en polymère à cristaux liquides, en polysulfure de phénylène, en polyéthylènetéréphtalate, en polyéthylène naphthalate, en polycétone, en polyéthercétone, en poly éther éther cétone, en poly éther cétone cétone, en poly éther éther cétone cétone, en polyéther imide, en polyéther sulfone, en copolymère de cyclooléfine et en polyamide.

5. Composite de feuilles suivant une des revendications 1 à 4, **caractérisé en ce que** la colle ou la laque de revêtement est choisie parmi le groupe comprenant des acrylates, des polyuréthanes, des polyol polyesters , des polyesterurétanes, des époxydes, des copolyesters ou des résines de colle naturelles, qui sont utilisées comme système à une ou plusieurs constituants.

6. Composite de feuilles suivant une des revendications 1 à 5, **caractérisé en ce que** le poids d'application à l'état humide de la colle de revêtement est compris entre 2 g/m² et 40 g/m², de préférence entre 4 g/m² à 10 g/m².

7. Composite de feuilles suivant une des revendications 3 à 6, **caractérisé en ce que** la substance thermoactivable est choisie parmi le groupe comprenant des copolymères de cyclooléfine, des polyesters, des polyuréthanes, des acrylates et leurs dérivés, des copolymères d'acétate vinylique, des alcools polyvinyliques, des polybutyraux de vinyle, des acétates de polyvinyle, des résines maléiques, des résines alkydes, des polyoléfines, des polyamides, ainsi que des copolyesters saturés, insaturés, linéaires et/ou ramifiés ou des systèmes de couche de base de polyuréthane à plusieurs constituants.

8. Composite de feuilles suivant une des revendications 1 à 7, **caractérisé en ce que** la première feuille et la seconde feuille des différentes feuilles composées présentent respectivement une épaisseur de 10 µm à 100 µm.

9. Procédé de fabrication d'un composite de feuilles sans halogène comprenant les étapes suivantes :
- Application d'une colle de revêtement sur une première feuille d'une première feuille composée scellable,
- Séchage de cette première feuille dans un tunnel de séchage à une température de 80° et 180°C, de préférence de 100° à 120°C,
- A la sortie du tunnel de séchage, liaison d'une seconde feuille à la première feuille, afin de réaliser une feuille composée scellable,
- Durcissement de la colle de revêtement de cette première feuille composée,
- Intégration d'une couche fonctionnelle supplémentaire ou d'un élément fonctionnel supplémentaire choisis parmi le groupe comprenant une plaquette imprimée, un détecteur, un cordon métallique ou une matière conductrice métallique, tel que le cuivre, l'argent, le fer, le nickel, l'aluminium ou un alliage de ces métaux, ou d'un composant électronique, entre la première feuille composée scellable et une seconde feuille composée scellable qui est fabriquée de manière identique à la première feuille composée, et
- laminage de la première feuille composée avec la seconde feuille composée.

10. Procédé suivant la revendication 9, **caractérisé en ce que** le composite de feuilles est constitué de 2 à x feuilles composées multicouches scellables au moins, x étant un nombre entier de 3 à 10.

11. Procédé suivant une des revendications 9 ou 10, **caractérisé en ce que** la seconde feuille des feuilles composées individuelles est revêtue d'une substance thermoactivable.

12. Procédé suivant une des revendications 9 à 11, **caractérisé en ce que** la première et la seconde feuille de chaque feuille composée isolée sont identiques ou différentes l'une par rapport à l'autre et qu'elles sont choisies parmi un groupe comprenant des feuilles en polymère à cristaux liquides, en polysulfure de phénylène, en polyéthylènetéréphtalate, en polyéthylènenaphthalate, en polycétone, en polyéthercétone, en poly éther éther cétone, en poly éther cétone cétone, en poly éther éther cétone cétone, en polyéther imide, en polyéther sulfone, en polysulfone, en coopolymère de cyclooléfine et en polyamide.

13. Procédé suivant une des revendications 9 à 12, **caractérisé en ce que** la colle de revêtement est choisie parmi le groupe comprenant des acrylates, des polyuréthanes, des polyol polyesters, des polyesteruréthanes, des époxydes, des copolyesters ou des résines de colle naturelles, qui sont utilisées comme système à un ou plusieurs constituants.

14. Procédé suivant une des revendications précédentes 9 à 13, **caractérisé en ce que** le poids d'application en état humide de la colle de revêtement est de 2g/m² à 40 g/m², de préférence de 4 g/m² à 10 g/m².

15. Procédé suivant la revendication 11, **caractérisé en ce que** la substance thermoactivable est choisie parmi le groupe comprenant des polymères de cyclooléfines, des polyesters, des polyuréthanes, des acrylates et leurs dérivés, des copolymères d'acétate vinylique, des alcools polyvinyliques, des polybutyraux de vinyle, des acétates de polyvinyle, des résines maléiques scellables, des résines alkydes, des polyoléfines, des polyamides, ainsi que des copolyesters saturés, insaturés, linéaires et/ou ramifiés ou des systèmes de couche de base de polyuréthane à plusieurs constituants.

16. Procédé suivant une des revendications précédentes 9 à 15, **caractérisé en ce que** la première et la seconde feuille de chaque feuille composée isolée présente une épaisseur de 10 µm à 100 µm.

17. Utilisation du composite de feuilles suivant une des revendications 1 à 8 comme feuille de couverture et/ou feuille de protection pour pistes conductives souples, composants électroniques, détecteurs.

18. Utilisation du composite de feuilles suivant une des revendications 1 à 8 pour la fabrication de câbles plats.

19. Utilisation du composite de feuilles suivant une des revendications 1 à 8 pour le blindage électromagnétique en liaison avec une couche électroconductrice, **caractérisée en ce qu'**une couche de métal est vaporisée soit entre les feuilles composées isolées, soit sur le composite de feuilles fini.

20. Utilisation suivant la revendication 19, **caractérisé en ce que** la couche de métal vaporisée est en cuivre ou en aluminium.
